(19) Europäisches Patentamt
European Patent Office
Office européen des brevets

(11) **EP 4 694 603 A1**

(12) **EUROPEAN PATENT APPLICATION**
published in accordance with Art. 153(4) EPC

(43) Date of publication:
**11.02.2026 Bulletin 2026/07**

(21) Application number: **23930880.2**

(22) Date of filing: **05.12.2023**

(51) International Patent Classification (IPC):
**H05K 9/00** $^{(2006.01)}$    **B32B 7/025** $^{(2019.01)}$
**H01Q 17/00** $^{(2006.01)}$

(52) Cooperative Patent Classification (CPC):
**B32B 7/025; H01Q 17/00; H05K 9/00**

(86) International application number:
**PCT/JP2023/043461**

(87) International publication number:
**WO 2024/202255 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.03.2023 JP 2023053539**

(71) Applicant: **LINTEC CORPORATION**
**Itabashi-ku**
**Tokyo 173-0001 (JP)**

(72) Inventors:
• **SEKI Yuta**
**Tokyo 173-0001 (JP)**
• **TODAKA Masaya**
**Tokyo 173-0001 (JP)**
• **MATSUSHITA Taiga**
**Tokyo 173-0001 (JP)**

(74) Representative: **V.O.**
**P.O. Box 87930**
**2508 DH Den Haag (NL)**

(54) **ELECTROMAGNETIC WAVE ABSORBING MEMBER**

(57) Disclosed is an electromagnetic wave absorbing member (10) including a resistive layer (20), a spacer layer (30), and a reflective layer (40), wherein the resistive layer (20), the spacer layer (30), and the reflective layer (40) are laminated in that order, wherein the resistive layer (20) has a plurality of regions that are equal to each other in area in a plan view of the electromagnetic wave absorbing member (10) and that are different from each other in electromagnetic wave absorption characteristics, wherein each of the regions has two or more types of conductor patterns (22) formed parallel to each other on the spacer layer (30), wherein each of the two or more types of conductor patterns (22) is constituted by a plurality of units arranged in one direction at regular intervals, and wherein each region is different from another adjacent region in at least one of a shape of the unit constituting the conductor pattern (22), a size of the unit, and an arrangement interval between the units.

FIG. 4

**Description**

TECHNICAL FIELD

The present invention relates to an electromagnetic wave absorbing member.

Priority is claimed on Japanese Patent Application No. 2023-053539, filed March 29, 2023, the content of which is incorporated herein by reference.

BACKGROUND ART

Sheet-shaped electromagnetic wave absorbing members that selectively absorb electromagnetic waves with a predetermined frequency are known. An electromagnetic wave absorbing member includes, for example, a first frequency selective shielding layer and a second frequency selective shielding layer. In such an electromagnetic wave absorbing member, due to fine line patterns of frequency selective surface (FSS) elements formed in the first frequency selective shielding layer and the second frequency selective shielding layer, each layer absorbs electromagnetic waves with a predetermined frequency, and as a whole electromagnetic waves with two different frequencies are selectively shielded.

Patent Document 1 describes a frequency selective surface on which circuit elements can be disposed in a number less than the number of conductors.

Patent Document 2 describes a radio wave absorber which has a structure in which a full-surface conductor layer made of a conductor, a first dielectric layer, a highresistance conductor layer having a surface resistivity within a predetermined range, a second dielectric layer, and a pattern layer having a plurality of patterns made of a conductor are sequentially laminated and in which each pattern in the pattern layer is different from another adjacent pattern in at least one of size and shape.

Citation List

Patent Document

Patent Document 1: Japanese Patent No. 6861907
Patent Document 2: Japanese Patent No. 4461974

SUMMARY OF INVENTION

Technical Problem

However, in the inventions described in Patent Documents 1 and 2, in a case in which the spacer layer has a large variation in thickness, it is not possible to obtain an electromagnetic wave absorbing member that has stable performance.

The present invention has been made in view of the above circumstances and an object of the present invention is to provide an electromagnetic wave absorbing member that has stable performance even when a spacer layer has a large variation in thickness. Solution to Problem

The present invention provides the following electromagnetic wave absorbing member.

[1] An electromagnetic wave absorbing member comprising a resistive layer, a spacer layer, and a reflective layer,

wherein the resistive layer, the spacer layer, and the reflective layer are laminated in that order,
wherein the resistive layer has a plurality of regions that are equal to each other in area in a plan view of the electromagnetic wave absorbing member and that are different from each other in electromagnetic wave absorption characteristics,
wherein each of the regions has two or more types of conductor patterns formed parallel to each other on the spacer layer,
wherein each of the two or more types of conductor patterns is constituted by a plurality of units arranged in one direction at regular intervals, and
wherein each region is different from another adjacent region in at least one of a shape of the unit constituting the conductor pattern, a size of the unit, and an arrangement interval between the units.

[2] The electromagnetic wave absorbing member according to claim 1,

wherein the regions are provided repeatedly at regular intervals.

Advantageous Effects of Invention

According to the present invention, it is possible to provide an electromagnetic wave absorbing member that has stable performance even when a spacer layer has a large variation in thickness.

BRIEF DESCRIPTION OF DRAWINGS

[FIG. 1] A view which schematically shows an electromagnetic wave absorbing member according to an embodiment of the present invention and which is a crosssectional view of a surface along a thickness of the electromagnetic wave absorbing member.

[FIG. 2] A plan view which schematically shows one region of a resistive layer of the electromagnetic wave absorbing member according to the embodiment of the present invention.

[FIG. 3] A top view which shows an example of the resistive layer constituting the electromagnetic wave absorbing member according to the embodiment of the present invention.

[FIG. 4] A top view which shows an example of a resistive layer constituting an electromagnetic wave absorbing member according to an embodiment of the present invention.

[FIG. 5] A top view which shows an example of a resistive layer constituting an electromagnetic wave absorbing member according to an embodiment of the present invention.

DESCRIPTION OF EMBODIMENTS

Embodiments of an electromagnetic wave absorbing member of the present invention will be described.
The present embodiment is specifically described to better understand the gist of the invention and does not limit the present invention unless otherwise specified.
In this specification, the term "conductor pattern" is an aggregate of units which are geometric figures and refers to an object that selectively absorbs electromagnetic waves with a certain frequency. The "conductor pattern" can be said to have a function similar to that of a so-called antenna.
In this specification, "electromagnetic waves in a millimeter wave range" refers to electromagnetic waves with a wavelength of 1 mm to 10 mm. The "electromagnetic waves in a millimeter wave range" can also be said to be electromagnetic waves with a frequency of 30 GHz to 300 GHz.
In this specification, the use of "to" indicating a range of values means that the values before and after "to" are included as a lower limit value and an upper limit value.

[Electromagnetic wave absorbing member]

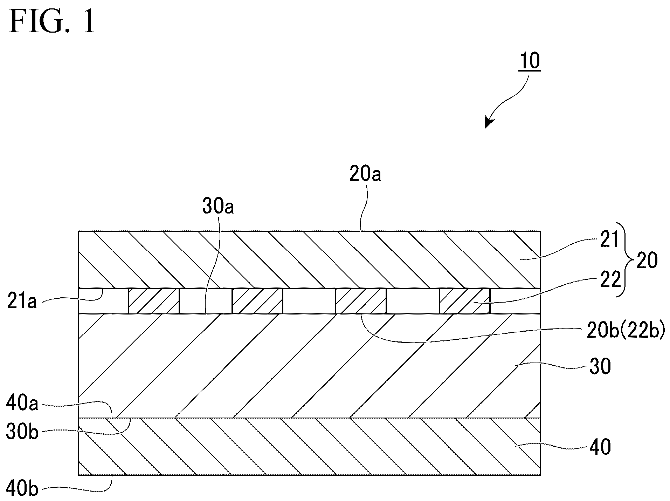

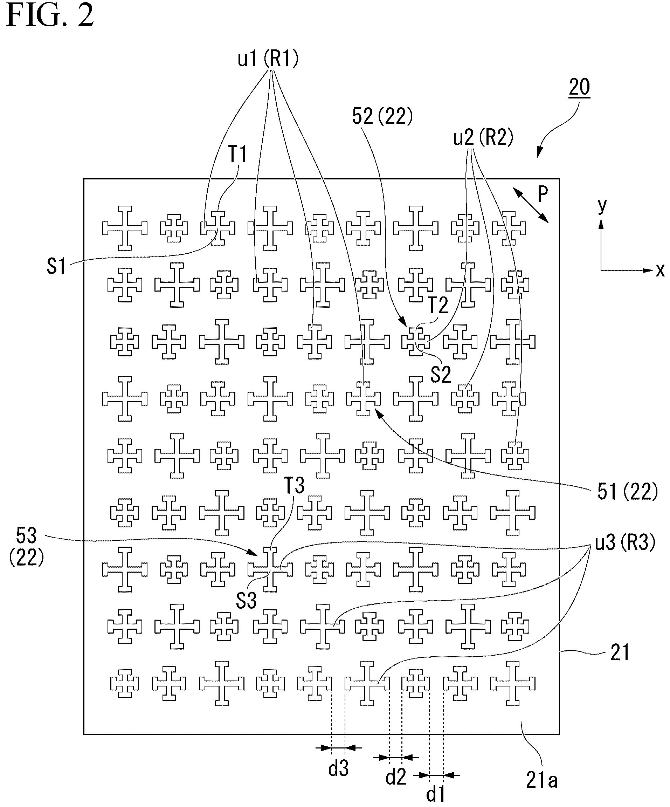

FIG. 1 is a view which schematically shows an electromagnetic wave absorbing member according to an embodiment of the present invention and which is a crosssectional view of a surface along a thickness of the electromagnetic wave absorbing member. FIG. 2 is a plan view which schematically shows one region of the electromagnetic wave absorbing member according to the embodiment of the present invention.
As shown in FIG. 1, an electromagnetic wave absorbing member 10 of the present embodiment has a resistive layer 20, a spacer layer 30, and a reflective layer 40. In addition, the resistive layer 20, the spacer layer 30, and the reflective layer 40 are laminated in that order.
The reflective layer 40 is disposed on a side of the other surface (a back surface) 20b of the resistive layer 20. The spacer layer 30 is disposed between the resistive layer 20 and the reflective layer 40. That is, the resistive layer 20 and the reflective layer 40 are laminated with the spacer layer 30 interposed therebetween.
The resistive layer 20 may be a single layer or may include a substrate 21 and a conductor pattern 22 formed on the substrate 21 as shown in FIG. 1.
In a case in which the resistive layer 20 is a single layer, the resistive layer 20 is made of the same material as the conductor pattern 22 which will be described below.

"Resistive layer"

The resistive layer 20 is made up of a frequency selective surface (FSS). The frequency selective surface is a surface that can block or transmit only electromagnetic waves with a specific frequency by forming a continuous structure with a shape smaller than a wavelength using a conductive member or the like.

FIG. 2 is a top view which shows one region of the resistive layer in the present embodiment as an example. As shown in FIG. 2, the resistive layer 20 has the substrate 21 having a flat-plate shape and the conductor pattern 22 formed on one surface 21a of the substrate 21. The conductor pattern 22 is made up of a first conductor pattern 51, a second conductor pattern 52, and a third conductor pattern 53.

(First conductor pattern)

As shown in FIG. 2, the first conductor pattern 51 is constituted by a plurality of first units u1. Each of the first units u1 is a geometric figure.

In other words, the first conductor pattern 51 can be said to be an aggregate of the first units u1 which are geometric figures.

Each of the first units u1 functions as an antenna. The first conductor pattern 51 may be, for example, a fine line pattern of an FSS element.

In the first conductor pattern 51, a plurality of first arrays R1 in each of which the plurality of first units u1 are arranged in a direction indicated by a double-headed arrow P in FIG. 2 are formed. It can also be said that the first conductor pattern 51 has the plurality of first arrays R1. The first conductor pattern 51 can be made by forming the plurality of first arrays R1 on the substrate 21 at predetermined intervals in the direction indicated by the double-headed arrow P.

The interval between the plurality of first arrays R1 is not particularly limited. The intervals between the first arrays R1 may be regular or irregular.

As shown in FIG. 2, the shape of each of the first units u1 is a cross shape that is vertically and horizontally symmetrical. Specifically, the first unit u1 has one cross portion S1 and four end portions T1. The cross portion S1 is constituted by a straight line portion parallel to an x-axis direction and a straight line portion parallel to a y-axis direction in FIG. 2. The end portions T1 each having a straight line shape are in contact with both ends of the straight line portion parallel to the x-axis direction and both ends of the straight line portion parallel to the y-axis direction so as to be perpendicular to the straight line portions.

By adjusting the length of the first unit u1 in the x-axis direction and the length of each of the four end portions T1 in the x-axis direction, the electromagnetic wave transmission characteristics of the first unit u1 that functions as a single antenna can be adjusted. Similarly, the electromagnetic wave transmission characteristics can be adjusted in the y-axis direction.

However, the shape of the first unit u1 is not limited to a cross shape. The shape of the first unit u1 is not particularly limited as long as the frequency value at which an amount of the electromagnetic waves transmitted by the first conductor pattern 51 indicates a maximum value is A [GHz].

Examples of the shape of the figure that is the first unit u1 include a circle shape, an annular shape, a straight line shape, a rectangular shape, a polygonal shape, an H shape, a Y shape, a V shape, and the like.

In the resistive layer 20, the plurality of first units u1 have the same shape. However, the shapes of the plurality of first units u1 do not have to be the same figure. In another example of the present invention, the shapes of the plurality of first units u1 may be the same or may be different from each other as long as the transmission characteristics can be adjusted to a desired frequency.

The first conductor pattern 51 selectively transmits the electromagnetic waves with a frequency of A [GHz]. The frequency value A [GHz] is a frequency value at which an amount of the electromagnetic waves transmitted by the first conductor pattern 51 indicates a maximum value in the range of 20 GHz to 110 GHz.

The first conductor pattern 51 transmits the electromagnetic waves with a frequency of A [GHz], which is specified by the above-described method X.

In the resistive layer 20 of the present embodiment, the frequency value A is preferably 20 GHz to 110 GHz, more preferably 60 GHz to 100 GHz, further preferably 65 GHz to 95 GHz, and particularly preferably 70 GHz to 90 GHz. When the frequency value A is within the above-described numerical range, the resistive layer 20 can transmit the electromagnetic waves in the millimeter wave region, making it easier to apply the electromagnetic wave absorbing member to an automobile part, a road surrounding member, a building exterior wall related material, a window, communication equipment, a radio telescope, or the like.

The material of the first unit u1 is not particularly limited as long as the transmission characteristics can be adjusted to the desired frequency.

Examples of the material of the first unit u1 include a fine wire of a metal, a conductive thin film, a conductive paste deposit, and the like.

Examples of the material of the metal include copper, aluminum, tungsten, iron, molybdenum, nickel, titanium, silver, gold, and alloys containing two or more of these metals (for example, steels such as stainless steel and carbon steel, brass, phosphor bronze, a zirconium-copper alloy, beryllium copper, iron-nickel, nichrome, nickeltitanium, Kanthal, Hastelloy, rhenium-tungsten, and the like).

Examples of the materials of the conductive thin film include metal particles, carbon nanoparticles, a carbon fiber, and the like.

The intervals between the end portions of the figures that are the first units u1 are not particularly limited as long as the transmission characteristics can be adjusted to the desired frequency.

For example, the intervals between the end portions of the figures that are the first units u1 may all be the same or may be different from each other. However, since it makes it easier to design a resistive layer that is less susceptible to the influence of the surrounding environment and it improves the precision of a frequency band of the electromagnetic waves absorbed during manufacturing, it is preferable that the intervals between the end portions of the figures that are the first units u1 be the same.

(Second conductor pattern)

As shown in FIG. 2, the second conductor pattern 52 is constituted by a plurality of second units u2.

The second conductor pattern 52 is formed in the same manner as the first conductor pattern 51.

The second conductor pattern 52 selectively transmits the electromagnetic waves with a frequency of B [GHz] that satisfies the following expression (2). The frequency value B [GHz] is a frequency value at which an amount of the electromagnetic waves transmitted by the second conductor pattern 52 indicates a maximum value. The frequency value B [GHz] satisfies the following expression (1).

$$1.037{\times}A \leq B \leq 1.30{\times}A \text{ ... Expression (1)}$$

As shown in the above expression (2), the second conductor pattern 52 transmits the electromagnetic waves with a frequency of $1.037{\times}A$ [GHz] to $1.30{\times}A$ [GHz]. The second conductor pattern 52 preferably transmits the electromagnetic waves with a frequency of $1.17{\times}A$ [GHz] to $1.30{\times}A$ [GHz].

Since the second conductor pattern 52 transmits the electromagnetic waves with a frequency of $1.037{\times}A$ [GHz] or higher, a peak of an amount of the electromagnetic waves transmitted by the second conductor pattern 52 and a peak of an amount of the electromagnetic waves transmitted by the first conductor pattern 51 sufficiently overlap with each other in a frequency band at a frequency higher than A [GHz]. As a result, the frequency band of the electromagnetic waves that can be transmitted through the entire electromagnetic wave absorbing film is expanded to a frequency band on a high-frequency side higher than A [GHz], compared with a film having the first conductor pattern 51 alone.

Since the second conductor pattern 52 transmits the electromagnetic waves with a frequency of $1.30{\times}A$ [GHz] or lower, a frequency difference between a peak of an amount of the electromagnetic waves transmitted by the second conductor pattern 52 and a peak of an amount of the electromagnetic waves transmitted by the first conductor pattern 51 becomes smaller in a frequency band at a frequency higher than A [GHz]. As a result, a single peak at which an amount of the electromagnetic waves transmitted through the entire electromagnetic wave absorbing film reaches a maximum value is formed.

As described above, since the second conductor pattern 52 transmits the electromagnetic waves with a frequency of $1.037{\times}A$ [GHz] to $1.30{\times}A$ [GHz], an amount of the electromagnetic waves transmitted through the entire electromagnetic wave absorbing film is expanded to a frequency band on the high-frequency side.

The material of the second unit u2 constituting the second conductor pattern 52 is not particularly limited as long as it is capable of absorbing the electromagnetic waves with B [GHz] and is not particularly limited as long as the absorption characteristics can be adjusted to the desired frequency.

The material of the second unit u2 is the same as that described for the material of the first unit u1.

(Third conductor pattern)

As shown in FIG. 2, the third conductor pattern 53 is constituted by a plurality of third units u3.

The third conductor pattern 53 is formed in the same manner as the first conductor pattern 51.

The third conductor pattern 53 selectively transmits the electromagnetic waves with a frequency of C [GHz] that satisfies the following expression (3). The frequency value C [GHz] is a frequency value at which an amount of the electromagnetic waves transmitted by the third conductor pattern 53 indicates a maximum value. The frequency value C [GHz] satisfies the following expression (2).

$$0.60{\times}A \le C \le 0.963{\times}A \ldots \text{Expression (2)}$$

As shown in the above expression (3), the third conductor pattern 53 transmits the electromagnetic waves with a frequency of $0.60{\times}A$ [GHz] to $0.963{\times}A$ [GHz]. The third conductor pattern 53 preferably transmits the electromagnetic waves with a frequency of $0.60{\times}A$ [GHz] to $0.83{\times}A$ [GHz].

Since the third conductor pattern 53 transmits the electromagnetic waves with a frequency of $0.60{\times}A$ [GHz] or higher, a frequency difference between a peak of an amount of the electromagnetic waves transmitted by the third conductor pattern 53 and a peak of an amount of the electromagnetic waves transmitted by the first conductor pattern 51 becomes smaller in a frequency band at a frequency lower than A [GHz]. As a result, a single peak at which an amount of the electromagnetic waves transmitted through the entire resistive layer 20 reaches a maximum value is formed.

Since the third conductor pattern 53 transmits the electromagnetic waves with a frequency of $0.963{\times}A$ [GHz] or lower, a peak of an amount of the electromagnetic waves transmitted by the third conductor pattern 53 and a peak of an amount of the electromagnetic waves transmitted by the first conductor pattern 51 sufficiently overlap with each other in a frequency band at a frequency lower than A [GHz]. As a result, the frequency band of the electromagnetic waves that can be transmitted through the entire electromagnetic wave absorbing film is expanded to a frequency band on a low-frequency side lower than A [GHz], compared with a film having the first conductor pattern 51 alone.

As described above, since the third conductor pattern 53 transmits the electromagnetic waves with a frequency of $0.60{\times}A$ [GHz] to $0.963{\times}A$ [GHz], an amount of the electromagnetic waves transmitted through the entire resistive layer 20 is expanded to a frequency band on the low-frequency side.

The material of the third unit u3 constituting the third conductor pattern 53 is not particularly limited as long as it is capable of transmitting the electromagnetic waves with C [GHz] and is not particularly limited as long as the transmission characteristics can be adjusted to the desired frequency.

The material of the third unit u3 is the same as that described for the material of the first unit u1.

In the resistive layer 20 shown in FIG. 2, the first array R1, a second array R2, and a third array R3 are arranged so as to be adjacent to each other in the direction indicated by the double-headed arrow P. In this way, the first array R1, the second array R2, and the third array R3 are disposed on the substrate 21 so as to be adjacent to each other, and therefore, the frequency band of the electromagnetic waves selectively transmitted by the second conductor pattern 52 and the frequency band of the electromagnetic waves selectively transmitted by the third conductor pattern 53 overlap with each other with the frequency value A [GHz] at a peak position of the electromagnetic waves selectively transmitted by the first conductor pattern 51 as a reference. As a result, the transmission range of the electromagnetic waves transmitted through the entire resistive layer 20 is easily expanded toward both the high-frequency side and the low-frequency side with the frequency value A [GHz] at the peak position as a reference.

An interval d1 between the first unit u1 and the second unit u2, an interval d2 between the second unit u2 and the third unit u3, and an interval d3 between the third unit u3 and the first unit u1, each shown in FIG. 2, may be the same or may be different from each other.

The interval d1 may be, for example, 0.2 mm to 4 mm, may be 0.3 mm to 2 mm, or may be 0.5 mm to 1 mm.

The interval d2 may be, for example, 0.2 mm to 4 mm, may be 0.3 mm to 2 mm, or may be 0.5 mm to 1 mm.

The interval d3 may be, for example, 0.2 mm to 4 mm, may be 0.3 mm to 2 mm, or may be 0.5 mm to 1 mm.

When the interval d1, the interval d2, and the interval d3 are each within the above-described numerical ranges, the transmission range of the electromagnetic waves transmitted through the entire resistive layer 20 is easily further expanded with the frequency value A [GHz] at the peak position as a reference.

In the resistive layer 20, the first unit u1, the second unit u2, and the third unit u3 have the same shape. However, the shapes of the first unit u1, the second unit u2, and the third unit u3 do not have to be the same figure. That is, in another example of the present invention, the shapes of the first unit u1, the second unit u2, and the third unit u3 may be the same or may be different from each other.

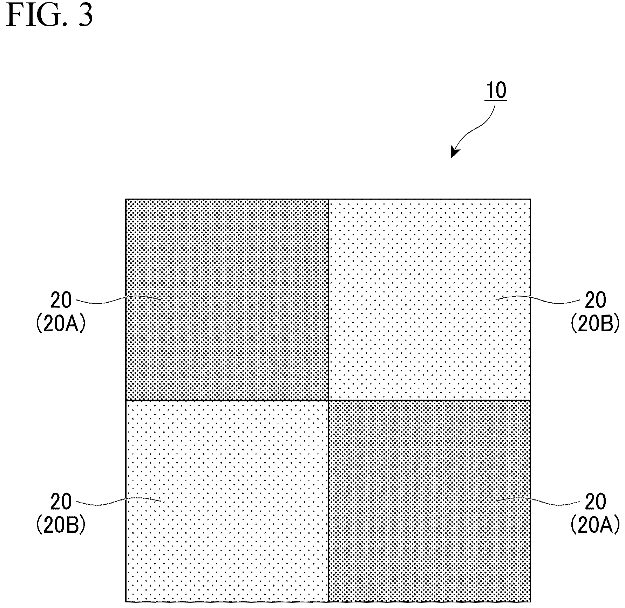

In the electromagnetic wave absorbing member 10 of the present embodiment, as shown in FIG. 3, the resistive layer 20 has two types of regions 20A and 20B that are equal to each other in area in a plan view of the electromagnetic wave absorbing member 10 and that are different from each other in electromagnetic wave absorption characteristics. The region 20A and the region 20B are equal to each other in shape. In the electromagnetic wave absorbing member 10 of the present embodiment, two types of regions 20A and 20B have a similar shape (here, a square shape) to the electromagnetic wave absorbing member 10 in a plan view of the electromagnetic wave absorbing member 10. In the electromagnetic wave absorbing member 10 of the present embodiment, in a plan view of the electromagnetic wave absorbing member 10, two regions 20A and two regions 20B are disposed diagonally across the resistive layer 20, and a diagonal of the two regions 20A is perpendicular to a diagonal of the two regions 20B. As a result, the regions 20A and 20B are adjacent to each other and disposed in a lattice pattern.

The region 20A and the region 20B each have, for example, the first conductor pattern 51, the second conductor pattern 52, and the third conductor pattern 53 which are described above.

The region 20A is different from the adjacent region 20B in at least one of a shape of the unit (the first unit u1, the second unit u2, the third unit u3) constituting the conductor pattern 22 (the first conductor pattern 51, the second conductor pattern 52, the third conductor pattern 53), a size of the unit, and an arrangement interval between the units. As a result, the region 20A and the region 20B are different from each other in electromagnetic wave transmission characteristics.

For example, in a case in which the region 20A has a plurality of conductor pattern groups as described above, it is preferable that region 20B have the same types of conductor pattern groups and that at least one of a surface area, a thickness, and an arrangement interval of each of the conductor pattern groups be reduced to a predetermined degree. Specifically, the surface area or the thickness of each of the conductor pattern groups in the region 20B is preferably 99% to 60% and more preferably 95% to 80% of that of each of the conductor pattern groups in the region 20A. In addition, the arrangement interval of the region 20B is preferably 99% to 60% and more preferably 90% to 70% of that of the regions 20A.

The substrate 21 is not particularly limited as long as it has a flat plate shape and allows the first conductor pattern 51, the second conductor pattern 52 and the third conductor pattern 53 to be formed on one surface 21a. The substrate 21 may have a single layer structure or a multi-layer structure.

The thickness of the substrate 21 may be, for example, 5 $\mu$m to 500 $\mu$m, 15 $\mu$m to 200 $\mu$m, or 25 $\mu$m to 100 $\mu$m.

The thickness of the first conductor pattern 51, the thickness of the second conductor pattern 52, and the thickness of the third conductor pattern 53 are not particularly limited. These thicknesses can be changed arbitrarily depending on the desired characteristics. In addition, these three thicknesses may be the same or may be different from each other, but in consideration of productivity, it is preferable that the three thicknesses be the same. From the viewpoint of achieving both electromagnetic wave transmission characteristics and curved surface conformability, the thickness of each of the first conductor pattern 51, the second conductor pattern 52, and the third conductor pattern 53 is preferably 10 nm to 300 $\mu$m, more preferably 40 nm to 100 $\mu$m, and particularly preferably 80 nm to 1 $\mu$m.

The material of the substrate 21 can be appropriately selected depending on the application of the electromagnetic wave absorbing member 10.

For example, for the purpose of providing transparency to the electromagnetic wave absorbing member 10, the substrate 21 may be made of a transparent material. In addition, for the purpose of providing a curved surface following property to the electromagnetic wave absorbing member 10, the substrate 21 may be made of a flexible material. For the purpose of improving the transparency and three-dimensional formability of the electromagnetic wave absorbing member 10, the surface of the substrate 21 may be smoothed.

For example, the substrate 21 can be made of a resin. The resin may be a thermoplastic resin or a thermosetting resin. However, in a case in which the three-dimensional formability of the electromagnetic wave absorbing member 10 is taken into consideration, the substrate 21 preferably contains a thermoplastic resin.

Examples of the thermoplastic resin include a polyolefin resin, a polyester resin, a polyester-polyether resin, a polyacrylic resin, a polystyrene resin, a polyimide resin, a polyimideamide resin, a polyamide resin, a polyurethane resin, a polycarbonate resin, a polyarylate resin, a melamine resin, an epoxy resin, a urethane resin, a silicone resin, and a fluororesin.

Specific examples of the polyolefin resin include polypropylene, polyethylene, and the like. Specific examples of the polyester resins include polyethylene terephthalate, polybutylene terephthalate, polyethylene naphthalate, and the like.

The substrate 21 may contain an optional component as long as the effects of the present invention are not impaired. Examples of the optional component include an inorganic filler, a colorant, a curing agent, an antioxidant, a light stabilizer, a flame retardant, a conductive agent, an antistatic agent, a plasticizer, and the like.

In consideration of further improving the electromagnetic wave absorbing performance of the electromagnetic wave absorbing member 10, the thickness, the dielectric constant, the electrical conductivity, and the magnetic permeability of the substrate 21 can be appropriately set.

In a case in which the electrical characteristics of the electromagnetic waves to be absorbed are taken into consideration, the substrate 21 may be a layer having a high dielectric constant. When the substrate 21 is a layer with a high dielectric constant, the thickness of the electromagnetic wave absorbing member 10 can be made relatively small.

The resistive layer 20 can be manufactured, for example, by the following method.

First, the substrate 21 is prepared. Next, the first conductor pattern 51, the second conductor pattern 52, and the third conductor pattern 53 are formed on one surface 21a of the substrate 21.

Each conductor pattern is formed such that the frequency value at which an amount of the electromagnetic waves transmitted by each conductor pattern indicates a maximum value is a predetermined value [GHz].

The order in which the conductor patterns are formed is not particularly limited. The conductor patterns may be formed in the same process or in separate processes.

The method for forming each conductor pattern is not particularly limited as long as it is possible to form a predetermined frequency. Examples of the method for forming each conductor pattern include the following methods.

A printing method in which each conductor pattern is printed on one surface 21a of the substrate 21 using a conductive paste.

A developing method in which each conductor pattern is developed on one surface 21a of the substrate 21.

A method in which a thin metal film is provided on one surface 21a of the substrate 21 by sputtering, vacuum deposition, or lamination of a metal foil and a pattern of the thin metal film is formed on one surface 21a of the substrate 21 by photolithography.

A method in which a metal wire is disposed on one surface 21a of the substrate 21.

"Spacer layer"

The spacer layer 30 is provided on the other surface 20b of the resistive layer 20.

The spacer layer 30 has two surfaces 30a and 30b. One surface 30a of the spacer layer 30 faces the other surface 20b of the resistive layer 20. The reflective layer 40 is provided on the other surface 30b of the spacer layer 30.

The spacer layer 30 may be a single layer structure or a multi-layer structure.

The material of the spacer layer 30 can be appropriately selected depending on the application, and examples of the material of the spacer layer 30 include a plastic film, paper, cloth, nonwoven fabric, a rubber sheet, a foamed sheet, and the like. Among these, the foamed sheet is preferred from the viewpoint of facilitating weight reduction while increasing the thickness.

As the foamed sheet, for example, a foamed sheet obtained by foaming a resin constituting the plastic film and forming the foamed resin into a sheet can be used. Specific examples of the foamed sheet include polyethylene foam, polypropylene foam, polyurethane foam, and the like.

In a case in which the wavelength shortening effect of the spacer layer 30 is taken into consideration, the thickness of the spacer layer 30 is appropriately changed according to the wavelength of the electromagnetic waves to be absorbed and the relative dielectric constant of the spacer layer 30.

In a case in which the wavelength shortening effect of the spacer layer 30 is taken into consideration, the thickness of the spacer layer 30 preferably satisfies the following expression (3).

$$(\text{Thickness of the spacer layer 30 in the z-axis direction}) = (\lambda) \times (1/4)/(\varepsilon)1/2 \ ...$$

Expression (3)

...

In the above-described expression (3), $\lambda$ is the wavelength of the electromagnetic waves that arrive, and $\varepsilon$ is the relative dielectric constant of the spacer layer 30. The thickness of the spacer layer 30 may be adjusted appropriately for the absorption characteristics. For example, the thickness of the spacer layer 30 can be changed within a range of 0.1 to 3.0 times the thickness of the spacer layer 30 obtained by the above-described expression (3).

In a case in which the relationship between the thickness of the spacer layer 30 and the wavelength $\lambda$ satisfies the above-described expression (3), the electromagnetic wave absorbing member 10 has a so-called $\lambda/4$ structure. As a result, a maximum value of an amount of the electromagnetic waves absorbed by the electromagnetic wave absorbing member 10 is further increased.

The thickness of the spacer layer 30 can be appropriately set depending on the wavelength $\lambda$ of the electromagnetic waves to be absorbed. The thickness of the spacer layer 30 may be, for example, 25 $\mu$m to 5000 $\mu$m, 300 $\mu$m to 4000 $\mu$m, or 1000 $\mu$m to 3000 $\mu$m.

The spacer layer 30 may be made of a material with a high dielectric constant. When the spacer layer 30 is a layer with a high dielectric constant, the thickness of the spacer layer 30 can be made relatively small.

In a case in which the dielectric constant of the spacer layer 30 is taken into consideration, the spacer layer 30 preferably contains at least one selected from the group consisting of barium titanate, titanium oxide, and strontium titanate.

"Reflective layer"

The reflective layer 40 has two surfaces 40a and 40b. One surface 40a of the reflective layer 40 faces the other surface 30b of the spacer layer 30.

The reflective layer 40 is not particularly limited as long as it can reflect the electromagnetic waves that arrive on the surface of the electromagnetic wave absorbing member 10 and is transmitted through the electromagnetic wave absorbing member 10. Some of the electromagnetic waves that arrive on the electromagnetic wave absorbing member 10 is reflected by the resistive layer 20 or absorbed by the resistive layer 20. On the other hand, the electromagnetic waves that are neither reflected nor absorbed by the resistive layer 20 are transmitted through the resistive layer 20. The electromagnetic waves transmitted through the resistive layer 20 are reflected by the reflective layer 40 toward the resistive layer 20.

For example, the reflective layer 40 can reflect the electromagnetic waves transmitted through the resistive layer 20 as long as it has conductivity in a surface direction of either of the two faces 40a and 40b. Specifically, a metal foil such as an aluminum foil or a copper foil, or a metal plate such as a copper plate bonded to a resin film such as a polyethylene terephthalate film may be used as the reflective layer 40. Instead of the metal foil or the metal plate, a transparent conductive film such as ITO, or a mesh sheet formed of a metal wire or the like may be used. Among these, the metal plate is preferred from the viewpoint of high electrical conductivity.

In consideration of the reflective characteristics of the reflective layer 40, the other surface 40b of the reflective layer 40 may be provided with a metal wire, a conductive thread, a twisted thread containing the metal wire and the conductive thread, or a conductive thin film. The conductive thin film can be provided on the surface 40b by, for example, a printing method such as screen printing, gravure printing, or inkjet printing; a sputtering method or vacuum deposition; or photolithography.

In a case in which the spacer layer 30 is formed on an object having electrical conductivity, such as a metal, the object having electrical conductivity, such as a metal, serves as the reflective layer 40, and therefore the reflective layer 40 can be omitted.

For the purpose of applying the electromagnetic wave absorbing member 10 to the surfaces of various articles, an adhesive layer may be provided on the other surface 40b of the reflective layer 40. In a case in which an adhesive layer is provided on the other surface 40b of the reflective layer 40, a release film may be provided on the surface of the adhesive layer opposite to the side in contact with the other surface 40b. The release film is removed when the electromagnetic wave absorbing member 10 is to be used. When the adhesive surface is covered with the release film, a handling property during distribution is improved.

Examples of an adhesive constituting the adhesive layer include a heat seal type adhesive that bonds by heat; an adhesive that develops stickiness when moistened; a pressure sensitive adhesive that bonds by pressure; and the like. Among these, from the viewpoint of simplicity, the pressure sensitive adhesive is preferred.

Specific examples of the pressure sensitive adhesive include an acrylic pressure sensitive adhesive, a urethane pressure sensitive adhesive, a rubber pressure sensitive adhesive, a polyester pressure sensitive adhesive, a silicone pressure sensitive adhesive, a polyvinyl ether pressure sensitive adhesive, and the like. Among these, at least one selected from the group consisting of the acrylic pressure sensitive adhesive, the urethane pressure sensitive adhesive, and the rubber pressure sensitive adhesive is preferred, and the acrylic pressure sensitive adhesive is more preferred.

In addition, the electromagnetic wave absorbing member 10 of the present embodiment may include a protective layer formed on one surface (a front surface) 20a of the resistive layer 20.

The protective layer is not particularly limited as long as it can protect the resistive layer 20.

According to the electromagnetic wave absorbing member 10 of the present embodiment, the resistive layer 20 has two types of regions 20A and 20B that are equal to each other in area in a plan view of the electromagnetic wave absorbing member 10 and that are different from each other in electromagnetic wave transmission characteristics, and the region 20A is different from the adjacent region 20B in at least one of a shape of the unit constituting the conductor pattern 22, a size of the unit, and an arrangement interval between the units. As a result, the region 20A and the region 20B are different from each other in electromagnetic wave transmission characteristics. In this way, since the resistive layer 20 is constituted by the region 20A and the region 20B which are different from each other in electromagnetic wave transmission characteristics, the electromagnetic wave transmission characteristics of the resistive layer 20 become average characteristics of the electromagnetic wave transmission characteristics of the region 20A and the electromagnetic wave transmission characteristics of the region 20B. As a result, even in a case in which the spacer layer 30 has a large variation in thickness, the variation in thickness can be cancelled out to obtain an electromagnetic wave absorbing member 10 having stable performance.

The electromagnetic wave absorption characteristics refer to the electromagnetic wave transmittance in the resistive layer 20 (the region 20A and the region 20B).

<Other embodiments>

The present invention is not limited to the above-described embodiment.

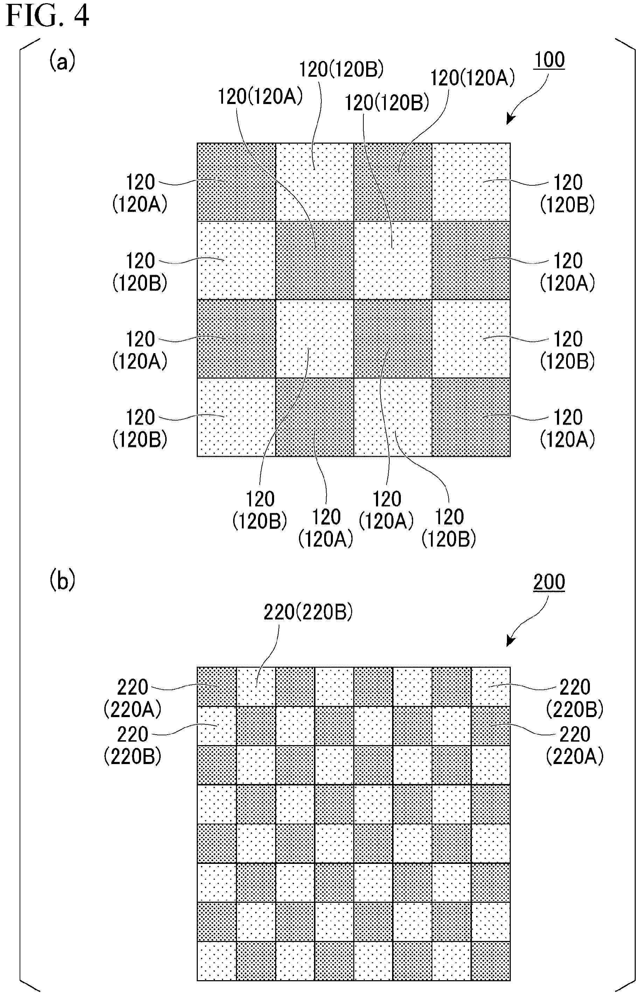

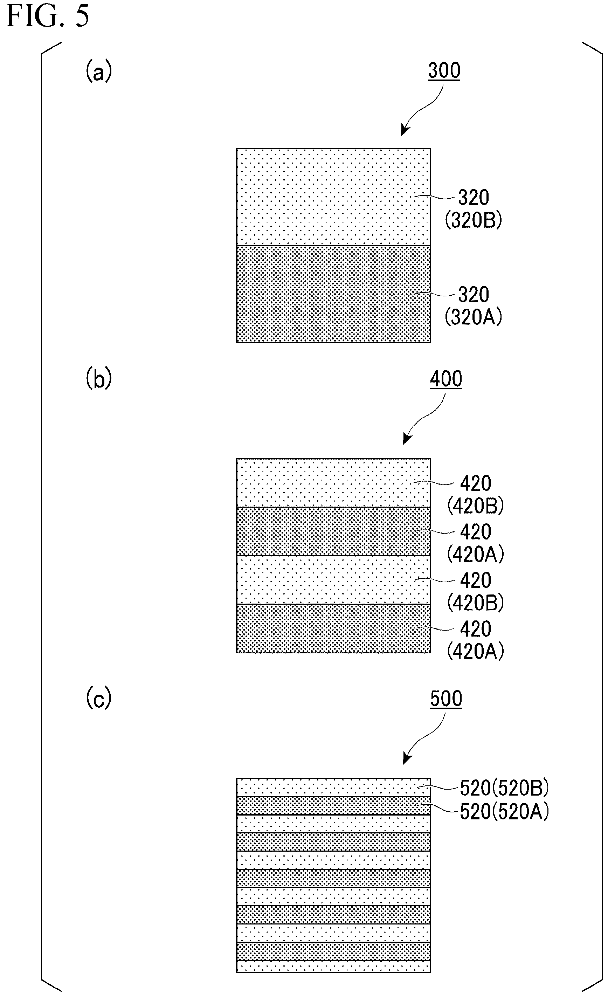

For example, configurations of electromagnetic wave absorbing members according to a first modification example to a sixth modification example shown in FIGS. 4A, 4B, 5A, 5B, and 5C may be adopted.

As in an electromagnetic wave absorbing member 100 according to the first modification example shown in FIG. 4A, a resistive layer 120 has two types of regions 120A and 120B that are equal to each other in area in a plan view of the electromagnetic wave absorbing member 100 and that are different from each other in electromagnetic wave transmission characteristics. The region 120A and the region 120B are equal to each other in shape. In the electromagnetic wave absorbing member 100 of the present embodiment, the regions 120A and 120B have a similar shape (here, a square shape) to the electromagnetic wave absorbing member 100 in a plan view of the electromagnetic wave absorbing member 100. In the electromagnetic wave absorbing member 100 of the present embodiment, in a plan view of the electromagnetic wave absorbing member 100, the regions 120A and the regions 120B are disposed alternately adjacent to each other, and eight regions 120A and eight regions 120B are disposed in a lattice shape.

The region 120A and the region 120B each have, for example, the first conductor pattern 51, the second conductor pattern 52, and the third conductor pattern 53 which are described above.

The region 120A is different from the adjacent region 120B in at least one of a shape of the unit (the first unit u1, the second unit u2, the third unit u3) constituting the conductor pattern 22 (the first conductor pattern 51, the second conductor pattern 52, the third conductor pattern 53), a size of the unit, and an arrangement interval between the units. As a result, the region 120A and the region 120B are different from each other in electromagnetic wave transmission characteristics.

In addition, it is preferable that the region 120A and the region 120B have the same relationships in terms of the surface area, the thickness, and the arrangement interval of the conductor pattern groups as the region 20A and the region 20B in FIG. 3.

As in an electromagnetic wave absorbing member 200 according to the second modification example shown in FIG. 4B, a resistive layer 220 has two types of regions 220A and 220B that are equal to each other in area in a plan view of the electromagnetic wave absorbing member 200 and that are different from each other in electromagnetic wave transmission characteristics. The region 220A and the region 220B are equal to each other in shape. In the electromagnetic wave absorbing member 200 of the present embodiment, the regions 220A and 220B have a similar shape (here, a square shape) to the electromagnetic wave absorbing member 200 in a plan view of the electromagnetic wave absorbing member 200. In the electromagnetic wave absorbing member 200 of the present embodiment, in a plan view of the electromagnetic wave absorbing member 200, the regions 220A and the regions 220B are disposed alternately adjacent to each other, and 32 regions 220A and 32 regions 220B are disposed in a lattice shape.

The region 220A and the region 220B each have, for example, the first conductor pattern 51, the second conductor pattern 52, and the third conductor pattern 53 which are described above.

The region 220A is different from the adjacent region 220B in at least one of a shape of the unit (the first unit u1, the second unit u2, the third unit u3) constituting the conductor pattern 22 (the first conductor pattern 51, the second conductor pattern 52, the third conductor pattern 53), a size of the unit, and an arrangement interval between the units. As a result, the region 220A and the region 220B are different from each other in electromagnetic wave transmission characteristics.

In addition, it is preferable that the region 220A and the region 220B have the same relationships in terms of the surface area, the thickness, and the arrangement interval of the conductor pattern groups as the region 20A and the region 20B in FIG. 3. Furthermore, the number of different types of regions is not limited to two, but may be three or more. For example, three different types of regions, that is, a region 220A, a region 220B, and a region 220C, may be repeated. In this case, at least one of the surface area, the thickness, and the arrangement interval of the conductor pattern groups in the region 220A is preferably 101% to 150% and more preferably 105% to 130% of that of the region 220B. At least one of the surface area, the thickness, and the arrangement interval of the conductor pattern groups in the region 220C is preferably 99% to 60% and more preferably 95% to 70% of that of the region 220B. In this case, it is preferable that the region 220A, the region 220B, and the region 220C be arranged repeatedly in that order.

As in an electromagnetic wave absorbing member 300 according to the third modification example shown in FIG. 5A, a resistive layer 320 has two types of regions 320A and 320B that are equal to each other in area in a plan view of the electromagnetic wave absorbing member 300 and that are different from each other in electromagnetic wave transmission characteristics. The region 320A and the region 320B are equal to each other in shape. In the electromagnetic wave absorbing member 300 of the present embodiment, the region 320A and the region 320B are disposed in one direction of the electromagnetic wave absorbing member 300 in a plan view of the electromagnetic wave absorbing member 300. That is, the region 320A and the region 320B are disposed in a band shape in one direction of the electromagnetic wave absorbing member 300.

The region 320A and the region 320B each have, for example, the first conductor pattern 51, the second conductor pattern 52, and the third conductor pattern 53 which are described above.

The region 320A is different from the adjacent region 320B in at least one of a shape of the unit (the first unit u1, the second unit u2, the third unit u3) constituting the conductor pattern 22 (the first conductor pattern 51, the second conductor pattern 52, the third conductor pattern 53), a size of the unit, and an arrangement interval between the units. As a result, the region 320A and the region 320B are different from each other in electromagnetic wave transmission characteristics.

In addition, it is preferable that the region 320A and the region 320B have the same relationships in terms of the surface area, the thickness, and the arrangement interval of the conductor pattern groups as the region 20A and the region 20B in FIG. 3.

As in an electromagnetic wave absorbing member 400 according to the fourth modification example shown in FIG. 5B, a resistive layer 420 has two types of regions 420A and 420B that are equal to each other in area in a plan view of the electromagnetic wave absorbing member 400 and that are different from each other in electromagnetic wave transmission characteristics. The region 420A and the region 420B are equal to each other in shape. In the electromagnetic wave absorbing member 400 of the present embodiment, the region 420A and the region 420B are disposed in one direction of the electromagnetic wave absorbing member 400 in a plan view of the electromagnetic wave absorbing member 400. That is, the region 420A and the region 420B are disposed in a band shape in one direction of the electromagnetic wave absorbing member 400. In the electromagnetic wave absorbing member 400 of the present embodiment, in a plan view of the electromagnetic wave absorbing member 400, the regions 420A and the regions 420B are disposed alternately adjacent to each other, and two regions 420A and two regions 420B are disposed in a band shape.

The region 420A and the region 420B each have, for example, the first conductor pattern 51, the second conductor pattern 52, and the third conductor pattern 53 which are described above.

The region 420A is different from the adjacent region 420B in at least one of a shape of the unit (the first unit u1, the second unit u2, the third unit u3) constituting the conductor pattern 22 (the first conductor pattern 51, the second conductor pattern 52, the third conductor pattern 53), a size of the unit, and an arrangement interval between the units. As a result, the region 420A and the region 420B are different from each other in electromagnetic wave transmission characteristics.

In addition, it is preferable that the region 420A and the region 420B have the same relationships in terms of the surface area, the thickness, and the arrangement interval of the conductor pattern groups as the region 20A and the region 20B in FIG. 3.

As in an electromagnetic wave absorbing member 500 according to the fifth modification example shown in FIG. 5C, a resistive layer 520 has two types of regions 520A and 520B that are equal to each other in area in a plan view of the electromagnetic wave absorbing member 500 and that are different from each other in electromagnetic wave transmission characteristics. The region 520A and the region 520B are equal to each other in shape. In the electromagnetic wave absorbing member 500 of the present embodiment, the region 520A and the region 520B are disposed in one direction of the electromagnetic wave absorbing member 500 in a plan view of the electromagnetic wave absorbing member 500. That is, the region 520A and the region 520B are disposed in a band shape in one direction of the electromagnetic wave absorbing member 500. In the electromagnetic wave absorbing member 500 of the present embodiment, in a plan view of the electromagnetic wave absorbing member 500, the regions 520A and the regions 520B are disposed alternately adjacent to each other, and five regions 520A and five regions 520B are disposed in a band shape.

The region 520A and the region 520B each have, for example, the first conductor pattern 51, the second conductor pattern 52, and the third conductor pattern 53 which are described above.

The region 520A is different from the adjacent region 520B in at least one of a shape of the unit (the first unit u1, the second unit u2, the third unit u3) constituting the conductor pattern 22 (the first conductor pattern 51, the second conductor pattern 52, the third conductor pattern 53), a size of the unit, and an arrangement interval between the units. As a result, the region 520A and the region 520B are different from each other in electromagnetic wave transmission characteristics.

In addition, it is preferable that the region 520A and the region 520B have the same relationships in terms of the surface area, the thickness, and the arrangement interval of the conductor pattern groups as the region 20A and the region 20B in FIG. 3. Furthermore, the number of different types of regions is not limited to two, but may be three or more. For example, three different types of regions, that is, a region 520A, a region 520B, and a region 520C, may be repeated. In this case, at least one of the surface area, the thickness, and the arrangement interval of the conductor pattern groups in the region 520A is preferably 101% to 150% and more preferably 105% to 130% of that of the region 520B. At least one of the surface area, the thickness, and the arrangement interval of the conductor pattern groups in the region 520C is preferably 99% to 60% and more preferably 95% to 70% of that of the region 520B. In this case, it is preferable that the region 520A, the region 520B, and the region 520C be arranged repeatedly in that order.

[Examples]

Hereinafter, the present invention will be described in more detail with reference to examples and comparative examples, but the present invention is not limited to the following examples.

[Comparative Example 1]

"Manufacture of electromagnetic wave absorbing member"

A water-washable ink was pattern-printed on a substrate made of a PET film (product name: PET50A4160, manufactured by Toyobo Co., Ltd.) having a thickness of 50 μm, and copper was deposited thereon to have a thickness of 100 nm, and thus a thin copper film is formed.

Thereafter, the ink was washed off with water, and the thin copper film on the water-washable ink was removed, thereby patterning the remaining thin copper film into a conductor pattern and obtaining a resistive layer.

A urethane foam sheet (manufactured by Inoac Corporation) having a thickness of 1.80 mm as a spacer layer and an aluminum-deposited PET film (flexural rigidity: 8.33 Pa mm$^4$) as a reflective layer were laminated in that order on a back surface of the obtained resistive layer to manufacture an electromagnetic wave absorbing member having absorbency in a band of 76 to 81 GHz.

As the resistive layer, the resistive layer having the conductor pattern shown in FIG. 2 was formed. Specifically, among three types of patterns, that is, large-sized, medium-sized, and small-sized patterns, the medium-sized pattern was designed to have a size and a shape that maximized transmission characteristics at 79 GHz. In the large-sized pattern, a length of a cross portion was increased by 20% in comparison with the medium-sized pattern. In the small-sized pattern, a length of a cross portion was reduced by 20% in comparison with the small-sized pattern. A pattern width was the same for the large-sized, medium-sized, and small-sized patterns. In addition, for spacer layer thicknesses of 2.00 mm and 2.20 mm as examples of different thicknesses on the spacer layer side, the resistive layer was manufactured with the similar configuration.

[Comparative Example 2]

"Manufacture of electromagnetic wave absorbing member"

As for the resistive layer, the pattern widths of the large-sized, medium-sized, and small-sized patterns of Comparative Example 1 were kept the same, but the lengths of the cross portions of the large-sized, medium-sized, and small-sized patterns of Comparative Example 1 were reduced to 90%. In addition, a distance between the patterns was reduced to 75% of that in Comparative Example 1. Except for the above, the electromagnetic wave absorbing member of Comparative Example 2 was manufactured in the same manner as in Comparative Example 1.

[Example 1]

An electromagnetic wave absorbing member of Example 1 was manufactured in the same manner as in Comparative Example 1 except that the resistive layer shown in FIG. 3 was formed as the resistive layer. The size of each unit was 32 mm × 32 mm, large-sized, medium-sized, and small-sized patterns similar to Comparative Example 1 were disposed in an array of 15 × 15 in one unit, and large-sized, medium-sized, and small-sized patterns similar to Comparative Example 2 were disposed in an array of 20 × 20 in the other unit.

[Example 2]

An electromagnetic wave absorbing member of Example 2 was manufactured in the same manner as in Comparative Example 1 except that the resistive layer shown in FIG. 4A was formed as the resistive layer. The size of each unit was 12 mm × 12 mm, large-sized, medium-sized, and small-sized patterns similar to Comparative Example 1 were disposed in an array of 7 × 7 in one unit, and large-sized, medium-sized, and small-sized patterns similar to Comparative Example 2 were disposed in an array of 9 × 9 in the other unit.

[Example 3]

An electromagnetic wave absorbing member of Example 3 was manufactured in the same manner as in Comparative Example 1 except that the resistive layer shown in FIG. 4B was formed as the resistive layer. The size of each unit was 7 mm × 7 mm, large-sized, medium-sized, and small-sized patterns similar to Comparative Example 1 were disposed in an array of 4 × 4 in one unit, and large-sized, medium-sized, and small-sized patterns similar to Comparative Example 2 were disposed in an array of 5 × 5 in the other unit.

[Example 4]

An electromagnetic wave absorbing member of Example 4 was manufactured in the same manner as in Comparative Example 1 except that the resistive layer shown in FIG. 5A was formed as the resistive layer. The size of each unit was a 32 mm width in a band shape, large-sized, medium-sized, and small-sized patterns similar to Comparative Example 1 were disposed in 15 rows in one unit, and large-sized, medium-sized, and small-sized patterns similar to Comparative Example 2 were disposed in 20 rows in the other unit.

[Example 5]

An electromagnetic wave absorbing member of Example 5 was manufactured in the same manner as in Comparative Example 1 except that the resistive layer shown in FIG. 5B was formed as the resistive layer. The size of each unit was a 12 mm width in a band shape, large-sized, medium-sized, and small-sized patterns similar to Comparative Example 1 were disposed in 7 rows in one unit, and large-sized, medium-sized, and small-sized patterns similar to Comparative Example 2 were disposed in 7 rows in the other unit.

[Example 6]

An electromagnetic wave absorbing member of Example 6 was manufactured in the same manner as in Comparative Example 1 except that the resistive layer shown in FIG. 5C was formed as the resistive layer. The size of each unit was a 7 mm width in a band shape, large-sized, medium-sized, and small-sized patterns similar to Comparative Example 1 were disposed in 4 rows in one unit, and large-sized, medium-sized, and small-sized patterns similar to Comparative Example 2 were disposed in 4 rows in the other unit.

[Evaluation]

The electromagnetic wave absorbing members of Comparative Examples 1 and 2 and Examples 1 to 6 were evaluated as follows. The results are shown in Table 1.

[Electromagnetic wave absorbency]

S11 values (reflection coefficients) of the electromagnetic wave absorbing members of Comparative Examples 1 and 2 and Examples 1 to 6 at 76 to 81 GHz were acquired using a network analyzer by a free space method, and the electromagnetic wave absorption characteristics of the electromagnetic wave absorbing members were evaluated.

[Table 1]

| | Resistive layer pattern arrangement | Spacer layer thickness [mm] | 76 to 81 GH maximum absorptance [%] | 76 to 81 GH minimum absorptance [%] | Minimum value of maximum absorptance [%] | Minimum value of minimum absorptance [%] |
|---|---|---|---|---|---|---|
| Comparative Example 1 | FIG. 2 | 1.80 | 87.00% | 68.40% | 87.00% | 68.40% |
| | | 2.00 | 99.80% | 95.10% | | |
| | | 2.20 | 94.60% | 85.90% | | |
| Comparative Example 2 | FIG. 2 | 1.80 | 97.80% | 73.90% | 82.50% | 63.80% |
| | | 2.00 | 90.10% | 82.70% | | |
| | | 2.20 | 82.50% | 63.80% | | |
| Example 1 | FIG. 3 | 1.80 | 91.40% | 79.50% | 91.40% | 79.50% |
| | | 2.00 | 99.80% | 98.30% | | |
| | | 2.20 | 94.60% | 90.80% | | |
| Example 2 | FIG. 4A | 1.80 | 97.10% | 80.60% | 93.80% | 77.80% |
| | | 2.00 | 99.90% | 90.50% | | |
| | | 2.20 | 93.80% | 77.80% | | |
| Example 3 | FIG. 4B | 1.80 | 90.50% | 79.60% | 90.50% | 79.60% |
| | | 2.00 | 99.20% | 95.00% | | |
| | | 2.20 | 92.40% | 85.20% | | |
| Example 4 | FIG. 5A | 1.80 | 90.20% | 86.20% | 90.20% | 81.70% |
| | | 2.00 | 99.30% | 95.70% | | |
| | | 2.20 | 91.30% | 81.70% | | |

(continued)

|  | Resistive layer pattern arrangement | Spacer layer thickness [mm] | 76 to 81 GH maximum absorptance [%] | 76 to 81 GH minimum absorptance [%] | Minimum value of maximum absorptance [%] | Minimum value of minimum absorptance [%] |
|---|---|---|---|---|---|---|
| Example 5 | FIG. 5B | 1.80 | 92.10% | 77.10% | 88.50% | 77.10% |
| | | 2.00 | 96.10% | 93.60% | | |
| | | 2.20 | 88.50% | 80.90% | | |
| Example 6 | FIG. 5C | 1.80 | 95.70% | 76.60% | 91.00% | 76.60% |
| | | 2.00 | 98.50% | 91.50% | | |
| | | 2.20 | 91.00% | 77.60% | | |

From the results shown in Table 1, it was found that the electromagnetic wave absorbing members of Examples 1 to 6 have excellent electromagnetic wave absorbency.

On the other hand, it was found that the electromagnetic wave absorbing members of Comparative Examples 1 and 2 were inferior in electromagnetic wave absorbency.

INDUSTRIAL APPLICABILITY

The electromagnetic wave absorbing member of the present invention can be suitably used as an electromagnetic wave absorbing member for transportation equipment such as automobiles.

REFERENCE SIGNS LIST

10 Electromagnetic wave absorbing member
20 Resistive layer
20A, 20B Region
21 Substrate
22 Conductor pattern
30 Spacer layer
40 Reflective layer
51 First conductor pattern
52 Second conductor pattern
53 Third conductor pattern

**Claims**

1. An electromagnetic wave absorbing member comprising a resistive layer, a spacer layer, and a reflective layer,

   wherein the resistive layer, the spacer layer, and the reflective layer are laminated in that order,
   wherein the resistive layer has a plurality of regions that are equal to each other in area in a plan view of the electromagnetic wave absorbing member and that are different from each other in electromagnetic wave absorption characteristics,
   wherein each of the regions has two or more types of conductor patterns formed parallel to each other on the spacer layer,
   wherein each of the two or more types of conductor patterns is constituted by a plurality of units arranged in one direction at regular intervals, and
   wherein each region is different from another adjacent region in at least one of a shape of the unit constituting the conductor pattern, a size of the unit, and an arrangement interval between the units.

2. The electromagnetic wave absorbing member according to claim 1, wherein the regions are provided repeatedly at regular intervals.

FIG. 1

# FIG. 2

FIG. 3

FIG. 4

(a)

120(120B)

120(120A)    120(120B)    120(120A)    100

120
(120A)                                              120
                                                    (120B)

120
(120B)                                              120
                                                    (120A)

120
(120A)                                              120
                                                    (120B)

120
(120B)                                              120
                                                    (120A)

120          120          120          120
(120B)       (120A)       (120A)       (120B)

(b)

220(220B)                                    200

220
(220A)                                              220
                                                    (220B)
220
(220B)                                              220
                                                    (220A)

# FIG. 5

(a)

300

320
(320B)

320
(320A)

(b)

400

420
(420B)

420
(420A)

420
(420B)

420
(420A)

(c)

500

520(520B)
520(520A)

## INTERNATIONAL SEARCH REPORT

| | International application No. |
|---|---|
| | **PCT/JP2023/043461** |

---

**A. CLASSIFICATION OF SUBJECT MATTER**

**H05K 9/00**(2006.01)i; **B32B 7/025**(2019.01)i; **H01Q 17/00**(2006.01)i
FI:  H05K9/00 Q; B32B7/025; H01Q17/00

According to International Patent Classification (IPC) or to both national classification and IPC

**B. FIELDS SEARCHED**

Minimum documentation searched (classification system followed by classification symbols)

H05K9/00; B32B7/025; H01Q17/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2005-317945 A (NITTA CORPORATION) 10 November 2005 (2005-11-10)<br>paragraphs [0082], [0123]-[0125], fig. 1, 11 | 1-2 |
| A | JP 2022-56768 A (LINTEC CORPORATION) 11 April 2022 (2022-04-11)<br>paragraphs [0012]-[0015], [0055], [0056], fig. 1-3 | 1-2 |
| A | JP 2020-191398 A (TOKYO METROPOLITAN INDUSTRIAL TECHNOLOGY<br>RESEARCH INSTITUTE) 26 November 2020 (2020-11-26)<br>paragraphs [0023]-[0024], fig. 2 | 1-2 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **22 January 2024** | **06 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2023/043461**

| Patent document cited in search report | | | Publication date (day/month/year) | Patent family member(s) | Publication date (day/month/year) |
|---|---|---|---|---|---|
| JP | 2005-317945 | A | 10 November 2005 | (Family: none) | |
| JP | 2022-56768 | A | 11 April 2022 | (Family: none) | |
| JP | 2020-191398 | A | 26 November 2020 | (Family: none) | |

Form PCT/ISA/210 (patent family annex) (July 2022)

**EP 4 694 603 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023053539 A
- JP 6861907 B
- JP 4461974 B